# EUROPEAN PATENT APPLICATION

(11) **EP 1 401 101 A1**
(43) Date of publication of application: **24.03.2004**
(21) Application number: 02256551.9
(22) Date of filing: 20.09.2002
(51) Int. Cl.: H03K 17/785

(54) **Transistor photoelectric conversion drive circuit**

(71) Applicant: Yang, Tai-Her, Si-Hu Town, Dzan-Hwa (TW)
(72) Inventor: Yang, Tai-Her, Si-Hu Town, Dzan-Hwa (TW)
(74) Representative: Pratt, David Martin

(57) **Abstract**

A transistor photoelectric conversion drive circuit to excite coupled photoelectric conversion device by electric energy driven light emission device (EL101) or natural light source in the environment to generate electric energy of positive voltage to drive metal-oxide-silicon field effect transistor (MOSFET) or insulated gate bi-carrier transistor (IGBT) or any other high input resistance transistor while electric energy is stored at a slave negative voltage supply circuit device (VB101) by means of the electric energy of positive voltage so that upon the signal of positive voltage is cut off, negative voltage is inputted to gate and emitter of one or more than one high input resistance transistors to facilitate cutoff.

## Description

### BACKGROUND OF THE INVENTION

### (a) Field of the Invention

The present invention relates to an photoelectric conversion drive circuit of a transistor, andmore particularly, to one that comprised of a matching electric energy driven light emission device, e.g. an LED, a light bulb, any other type of photoelectric conversion light emission device or natural light source in the environment; an device coupled to the matching photoelectric conversion light emission device, such as an electricity storage device of an photo to electric energy crystal or a non-crystal system; and a voltage type drive electric energy that generates micro-current when subject to light, for transmission to high input resistance type of transistor, such as a micro or power type metal-oxide-silicon field effect transistor (MOSFET) or insulated gate bi-carrier transistor (IGBT) or other high input resistance transistor or a gate and emitter of a modulus for driven conduction. Meanwhile, a drive electric energy of a positive voltage is used to supply electric energy for storage by a circuit device of slave type of negative voltage so that upon cutting off, negative voltage is generated to input to gate and emitter of one or more than one high resistance transistors for facilitating the cut-off.

### (b) Description of the Prior Art:

A high input resistance transistor such as a metal-oxide-silicon field effect transistor (MOSFET) or an insulated gate bi-carrier transistor IGBT or any other type of high input resistance transistor or modulus is known as a solid-state transistor device voltage with its operation controlled by a drive voltage that has been developed only in recent years. In addition to functioning as a solid-state high power switch, the high input resistance transistor is convenient to be applied in micro-electronic logic operation or data memory storage circuit device or detection circuit device or other circuits. However, the input end for controlling the operation of the high input resistance transistor, e.g., MOSFET, IGBT or other types of high input resistance transistor or modulus is of high resistance type. The matching current of its drive signal is very small (approaching zero). Since the drive voltage must reach pre-set value to ensure of normal operation, larger resistance is observed between collector and emitter if voltage between gate and emitter gets too low, thus the high resistance input transistor may get burnt out due to increased thermal loss. Such a disadvantage makes the transistor be somehow limited when applied in the occasion with lower input voltage. -A

### SUMMARY OF THE INVENTION

The primary purpose of the present invention is to provide a circuit to drive a metal-oxide-silicon field effect transistor (MOSFET) or an insulated gate bi-carrier transistor (IGBT), or other type of high input resistance transistor by having an electric energy driven light emission device or an environmental light source to excite a device coupled to the photoelectric conversion light emission device or environmental light source to generate electric energy of positive voltage; and to generate negative voltage to gate and emitter of one or more than one high resistance transistor to facilitate cutting off.

### BRIEF DESCRIPTION OF THE DRAWINGS

Fig. 1 is a block chart showing a basic circuit of a photoelectric conversion drive circuit of the present invention of a transistor,
Fig. 2 is a view showing that the present invention is in parallel with induction to form a slave negative voltage supply circuit,
Fig. 3 is a view showing that the present invention is in parallel with induction and capacitors to form a slave negative voltage supply circuit,
Fig. 4 is a view showing that the present invention is in series with induction to form a slave negative voltage supply circuit,
Fig. 5 is a view showing that the present invention is in series with induction and capacitors in parallel to form a slave negative voltage supply circuit,
Fig. 6 is a view showing that the present invention is in series with resistance and secondary battery to form a slave negative voltage supply circuit.
Fig. 7 is a view showing that the present invention is in series with zener diode and secondary battery to form a slave negative voltage supply circuit,
Fig. 8 is a view showing that the present invention is in parallel with pressure effect system of pre-stressed structure to form a slave negative voltage supply circuit,
Fig. 9 is a view showing that a slave negative voltage supply circuit is comprised of the present invention and an photoelectric conversion device in series of inverse polarity with drive signals,
Fig. 10 is a view showing that a slave negative voltage supply circuit comprised of having connected the output from a device coupled to a photoelectric conversion light emission device of the present invention in series with zener diode and capacitors,
Fig. 11 is a view showing a circuit wherein the present invention provided with a negative voltage storage device simultaneously excites two photoelectric conversion device connected in series of inverse polarity coupled to the electric light emission device from a signal source,
Fig. 12 is a view showing another circuit wherein the present invention provided with a negative voltage storage device simultaneously excites two photoelectric conversion device connected in series of inverse polarity coupled to the electric light emission device from a signal source,
Fig. 13 is a view showing a circuit wherein the present invention is adapted by means of two electric energy driven light emission device driven by electric energy polarity selection to two photoelectric conversion device connected in parallel of inverse polarity,
Fig. 14 is a view showing a circuit wherein two individual electric energy driven light emission devices are used by the present invention to control the operation of two photoelectric conversion devices connected in parallel of inverse polarity,
Fig. 15 is a view showing another circuit wherein two individual electric energy driven light emission device are used by the present invention to control the operation of two photoelectric conversion device connected in parallel of inverse polarity,
Fig. 16 is a first preferred embodiment of the present invention comprised of a constant negative electric energy,
Fig. 17 is a second preferred embodiment of the present invention comprised of a constant negative electric energy, and
Fig. 18 is a third preferred embodiment of the present invention comprised of a constant negative electric energy.

### DETAILED DESCRIPTION OF THE PREFERRED EMBODIMENTS

The present invention relates to an photoelectric conversion drive circuit of a transistor, and more particularly, to one that comprised of a matching electric energy driven light emission device, e.g. an LED, a light bulb, any other type of photoelectric conversion light emission device or natural light source in the environment; an device coupled to the matching photoelectric conversion light emission device, such as an electricity storage device of an photo to electric energy crystal or a non-crystal system; and a voltage type drive electric energy that generates micro-current when subject to light, for transmission to high input resistance type of transistor, such as a micro or power type metal-oxide-silicon field effect transistor (MOSFET) or insulated gate bi-carrier transistor (IGBT) or other high input resistance transistor or a gate and emitter of amodulus for driven conduction. Meanwhile, a drive electric energy of a positive voltage is used to supply electric energy for storage by a circuit device of slave type of negative voltage so that upon cutting off, negative voltage is generated to input to gate and emitter of one or more than one high resistance transistors for facilitating the cut-off.

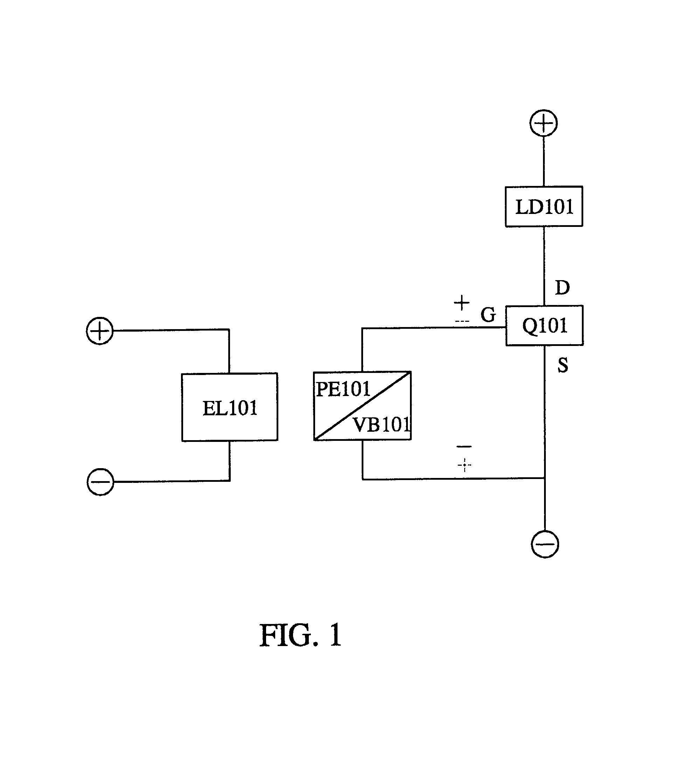

Fig. 1 is a block chart showing a basic circuit of a photoelectric conversion drive circuit of a transistor of the present invention essentially comprised of:
- a high input resistance transistor Q101: comprised of one or more than one various types of high input resistance transistor devices, including one-unit one-polarity or two units inversely connected in parallel, or bridge type modulus high input resistance transistor such as an active device comprised of a metal-oxide-silicon field effect transistor (MOSFET) or an insulated gate bi-carrier transistor (IGBT), or other high input resistance transistor or modulus or gate, or constitutes logic operation or data memory storage system, or detection circuit device, or constitutes other circuit that is driven by receiving electric energy drive signal of positive voltage, or one or more than one an photoelectric conversion devices PE101 is provided for j oint or individual matching as may be required to drive the high input resistance transistor Q101;
- a photoelectric conversion device PE101: comprised of a crystal or non-crystal system photo device that generates electric energy output when subject to light, or of other type of photoelectric conversion device to receive photo energy from an environmental light source or an electric energy driven light emission device EL101 and then the photo energy is converted into a minimum drive voltage required by the high input resistance transistor Q101 to drive the high input resistance transistor Q101; the electric energy driven light emission device EL101 comprised of one or more than one light emission diodes (LEDs) , electric bulb or any other type of photoelectric conversion device is matched to the an photoelectric conversion device PE101 in such way that the photo energy outputted generates the minimum drive voltage required by the photoelectric conversion device PE101; one or more than one electric energy driven light emission devices EL101 are used to drive the photoelectric conversion device PE101; or one or more than one electric energy driven light emission device EL101 are used to jointly drive the photoelectric conversion device PE101; or two or more than two electric energy driven light emission devices EL101 are used to respectively drive the photoelectric conversion device PE101; or two or more than two electric energy driven light emission devices EL101 are used to simultaneously drive two or more than two photoelectric conversion devices PE101; and one or more than one the electric energy driven light emission devices EL101 may be provided or not provided at all depending on the requirements of the circuit;
- a slave negative voltage supply circuit device VB101: comprised of solid-status or mechanic-electronic device to provide negative voltage upon cutting off for transmission to the control gate and emitter of the high input resistance transistor Q101 for facilitating the cutoff to be executed by the high input resistance transistor Q101; upon the delivery of the positive voltage electric energy signal controlling the drive, or when the photoelectric conversion device PE101 receives the photo energy emitted from the electric energy driven light emission device EL101 or from the environment to generate positive voltage to drive the high input resistance transistor Q101, the slave negative voltage supply circuit device VB101 executes storage of negative voltage at the same by means of electric energy of the inputted positive voltage signal so that when the positive voltage signal transmitting to the high input resistance transistor Q101 is interrupted, the slave negative voltage supply circuit device VB101 inputs negative voltage to the controlling gate and emitter of the high input resistance transistor Q101 to facilitate cut-off transition; the negative voltage electric energy of the slave negative voltage supply circuit device VB101 may come from a photoelectric conversion device includes that from the photoelectric conversion devices PE101 or an independently provided photoelectric conversion device PE102, or that positive voltage electric energy from other drive signal source; and the negative voltage storage is characterized by a mechanic-electronic device, an inductive device, a capacity device, a (dis) chargeable secondary battery or a super capacitor, or other type of electricity storage device to store electric energy of positive voltage required for driving the high input resistance transistor Q101;
- a loading device LD101 : includes a load generatingmechanical energy, photo, thermal or electrochemical effect by inputting electric energy, or any other power load comprised of resistive, capacity, inductive load or transistor or diode or any other solid-status or mechanical-electronic load device, or any circuit load functioning for post amplification, or any load for signal transmission, or any load for data storage or read-out or elimination or operation, or any load functioning as a detection circuit device or any other circuit load to be subject to the control by the high input resistance transistor Q101.

By combining those devices disclosed above, photoelectric conversion devices PE101 to generate a drive voltage under normal conditions of being subject to light in parallel, the slave negative voltage supply circuit device VB101 and the electric energy driven light emission device EL101 which can be coupled to the photoelectric conversion device PE101 such as the light emission diode (LED) or electric bulb is provided between the gate and the emitter from a high input resistance transistor such as a micro or power type metal-oxide-silicon field ef fect transistor (MOSFET) or an insulated gate bi-carrier transistor (IGBT) or other type of high input resistance transistor or modulus so that when the electric energy driven light emission device EL101 emits the light, or when the photoelectric conversion device PE101 is excited by the environmental light source, a relative drive voltage signal is generated to drive the high input resistance transistor Q101.

The structural configuration of the photoelectric conversion drive circuit of the transistor is described as follows:
(1) Depending on the structural requirements, the electric energy driven light emission device EL101, the photoelectric conversion device PE101 and the slave negative voltage supply circuit device VB101 may be of individual structure, or mutually coupled, or partially or generally coupled to form a sealed configuration;
(2) Depending on the structural requirements, the electric energy driven light emission device EL101, the photoelectric conversion device PE101 and the slave negative voltage supply circuit device VB101 may be partially or generally separately provided or packed into a modulus with the high input resistance transistor Q101;
(3) Each and all related circuit devices may be directly connected or connected via an I/C or a PCB to form an open structure or a hybrid structure;
(4) A drive source for the energy driven light emission device EL101referred in subparagraphs (1), (2) and (3) may be of DC or AC source to drive the bulb, or comprised of DC electric energy driven light emission diode (LED), or laser light source or other electric energy excited electric energy driven light emission device, or may be substituted with a natural light source from the environment.

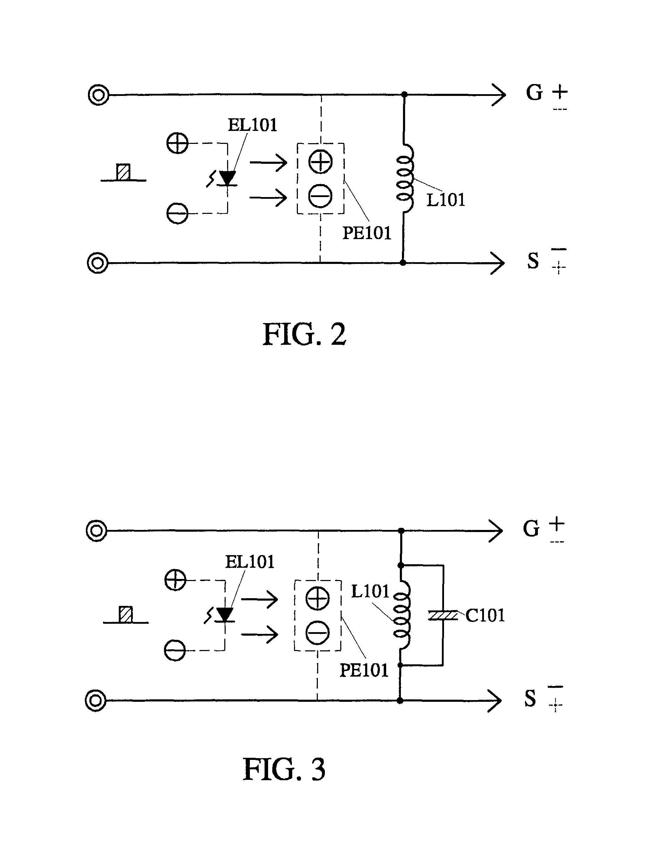

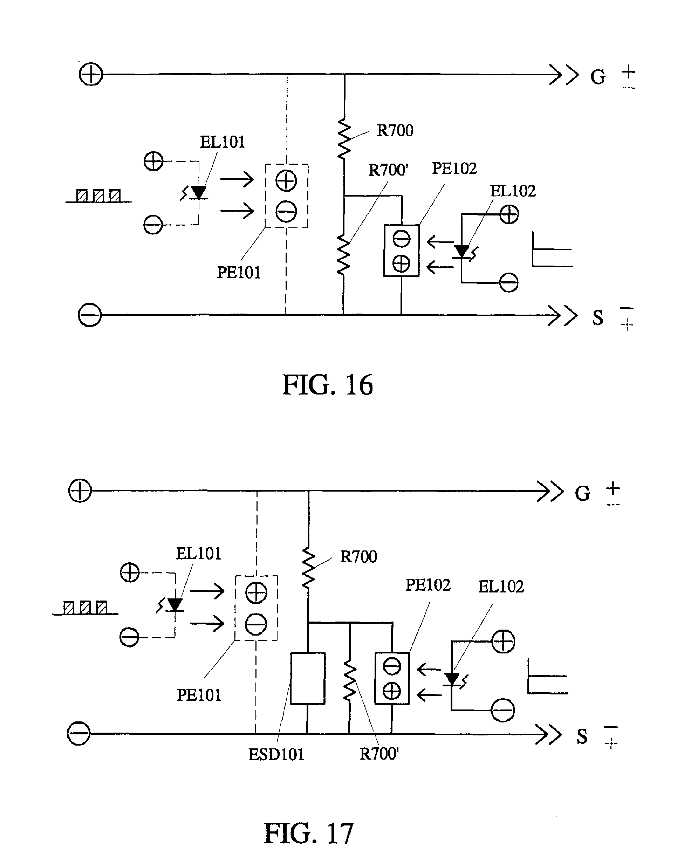

The essential composition of the slave negative voltage supply circuit device VB101 provided in the photoelectric conversion drive circuit of the transistor, is characterized by that with a combination of mechanical-electronic device or solid-state device, various types of electric energy of positive voltage signal functioning as the input drive are at the same time transferred and stored in the slave negative voltage supply circuit device VB101 so to function as a negative voltage source in helping cutoff when the high input resistance transistor Q101 is cut off; it is also characterized by that by taking advantage of the photo energy generated when the electric energy driven light emission device is subject to a light for emitting the light, the photoelectric conversion device PE101 or PE102 is excited to generate the positive voltage electric energy required to drive the high input resistance transistor while the positive voltage electric energy is transferred and stored in the slave negative voltage supply circuit device VB101 so to function as the negative voltage source to help energy transformation when the high input resistance transistor Q101 is cut off; whereas the circuit structure for the formation of the slave negative voltage supply circuit device VB101 is in great number, the following preferred embodiments are given only for references to prove the feasibility of the slave negative voltage supply circuit device VB101, and do not in any way limit the scope of its composition:
a. As illustrated in Fig. 2, the slave negative voltage supply circuit is comprised of the present invention in parallel with induction. Within, input end of the high input resistance transistor Q101 is used to connect an induction L101 in parallel so that when an external signal source or the positive voltage signal source used to drive the high input resistance transistor Q101 supplied from the photoelectric conversion device PE101 with selected output voltage coupled as controlled by the electric energy driven light emission device EL101 is interrupted, the induction L101 then generates a inverse negative voltage to the input end of the high input resistance transistor Q101 to improve its cutoff characteristics;
b. Fig. 3 shows that a slave negative voltage supply circuit comprised of the present invention is connected in parallel with induction and capacitor. Wherein, the input end of the high resistance transistor Q101 is connected in parallel with an induction L101 and capacitors C101 so that when an external signal source or the positive voltage signal source used to drive the high input resistance transistor Q101 supplied from the photoelectric conversion device PE101 with selected output voltage coupled as controlled by the electric energy driven light emission device EL101 is interrupted, the induction L101 and the capacitor C101 connected in parallel are used to generate inverse negative voltage to the input end of the high resistance transistor Q101 to improve its cutoff characteristics;

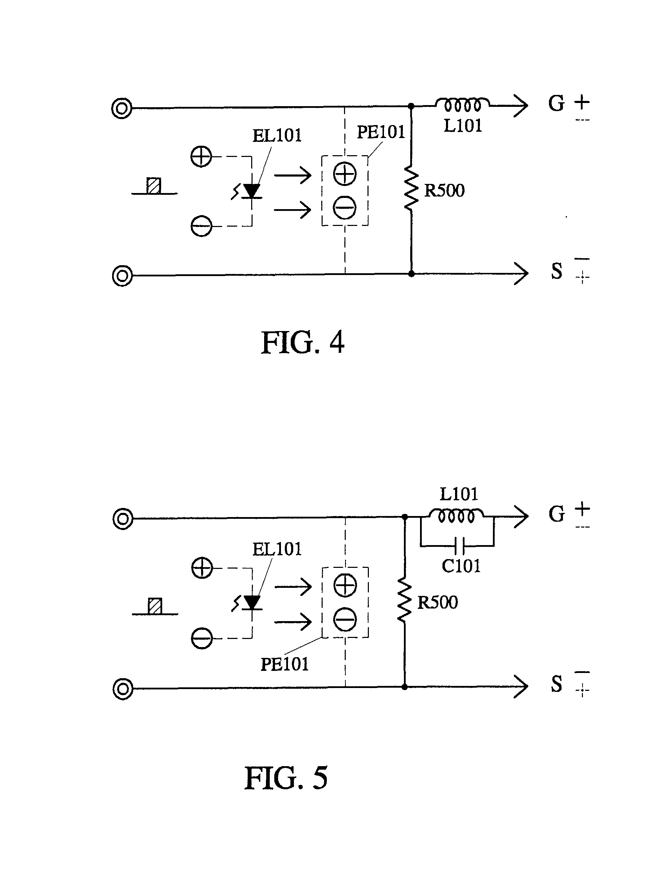

c. Fig. 4 shows that a slave negative voltage supply circuit comprised of the present invention is connected in series with an induction. Within, the induction L101 is connected in series between the input of the high input resistance transistor Q101 and a signal source of drive positive voltage so that when an external signal source or the positive voltage signal source used to drive the high input resistance transistor Q101 supplied from the photoelectric conversion device PE101 with selected output voltage coupled as controlled by the electric energy driven light emission device EL101 is interrupted, the induction L101 is connected in series between the signal source of drive positive voltage and the high input resistance transistor Q101 generates an inverse negative voltage to the input end of the high input resistance transistor Q101 to improve its cutoff characteristics, and a secondary resistance R500 may be connected in parallel with both ends of the photoelectric conversion device PE101 as required to provide a loop for the inverse negative voltage;
d. As illustrated in Fig. 5, a slave negative voltage the present invention is connected in series with an induction L101 and capacitors C101 connected in parallel so that when an external signal source or the positive voltage signal source used to drive the high input resistance transistor Q101 supplied from the photoelectric conversion device PE101 with selected output voltage coupled as controlled by the electric energy driven light emission device EL101 is interrupted, a parallel harmonic oscillation is formed comprising of the induction L101 and the capacitors C101 in parallel is connected in series between the high input resistance transistor Q101 and the signal source of drive positive voltage, and an inverse negative voltage is generated to the input end of the high input resistance transistor Q101toimproveitscutoffcharacteristicswhile a secondary resistance R500 may be connected as required in parallel with both ends of the photoelectric conversion device PE101 to provide a loop of inverse negative voltage;

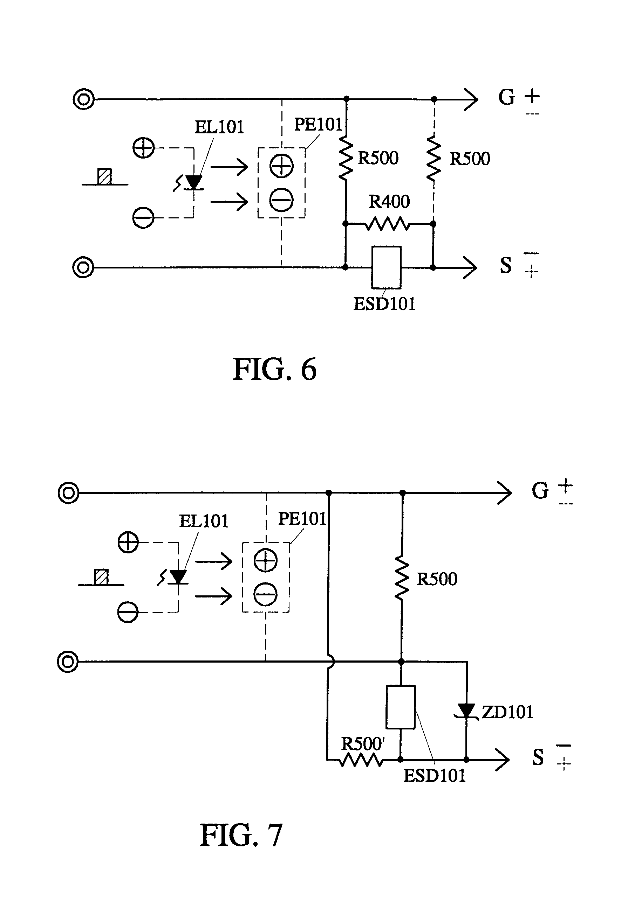

e. Fig. 6 shows that a slave negative voltage supply circuit is comprised of the present invention in series with resistance and a secondary battery system. Within, a combination of a resistance R400 and a secondary electricity storage device ESD101 in parallel is comprised of having the secondary battery system ESD101 comprised of the capacitor or the secondary (dis) chargeable battery and the resistance R400 in parallel to be connected in series between the drive signal source and the input of the high input resistance transistor Q101, and the secondary resistance R500 is connected in parallel with either side of a connection of the combination of the drive signal source and the resistance R400 connected in parallel with the secondary electricity storage device ESD101 and another end from the signal source of the drive positive voltage so to have the drive signal source or the photoelectric conversion device PE101 with the selected output voltage coupled as controlled by the electric energy driven light emission device EL101 to generate electricity when subject to light, thus to generate positive voltage to drive the high input resistance transistor Q101; and in addition to driving the high input resistance transistor Q101, the positive voltage also forms a voltage drop to the resistance R400 provided in the combination of the resistance R400 and the secondary electricity storage device ESD101 connected in parallel, so to charge the negative voltage into both ends of the secondary electricity storage device ESD101; furthermore, when the signal source of the positive voltage is interrupted, the negative voltage stored in the secondary electricity storage device ESD101 forms through the secondary resistance R500 a negative voltage to the input end of the high input resistance transistor Q101 to improve its cutoff characteristics;
f. Fig. 7 shows that that a slave negative voltage supply circuit is comprised of having the present invention connected in series with a combination of a zener diode and a secondary electricity storage device in parallel. Within, a combination of a resistance and a secondary electricity storage device in parallel is comprised of having the secondary electricity storage device ESD101 comprised of the capacitor or the secondary (dis) chargeable battery and a combination of a zener diode ZD101 and a secondary electricity storage device ESD101 in parallel to be connected in series between the drive signal source and the input of the high input resistance transistor Q101, and secondary resistance R500 and R500' are respectively connected in parallel with both ends of the combination of the zener diode ZD101 in parallel and the drive signal source so to have the drive signal source or the photoelectric conversion device PE101 with the selected output voltage coupled as controlled by the electric energy driven light emission device EL101 to generate electricity when subject to light, thus to generate positive voltage to drive the high input resistance transistor Q101; and in addition to driving the high input resistance transistor Q101, zener voltage of the zener diode ZD101 is used to form a voltage drop at both ends of the secondary electricity device ESD101 so to charge the negative voltage into both ends of the secondary electricity storage device ESD101; furthermore, when the signal source of the positive voltage is interrupted, the negative voltage stored in the secondary electricity storage device ESD101 forms through the secondary resistance R500 and R500' a negative voltage to the input end of the high input resistance transistor Q101 to improve its cutoff characteristics.

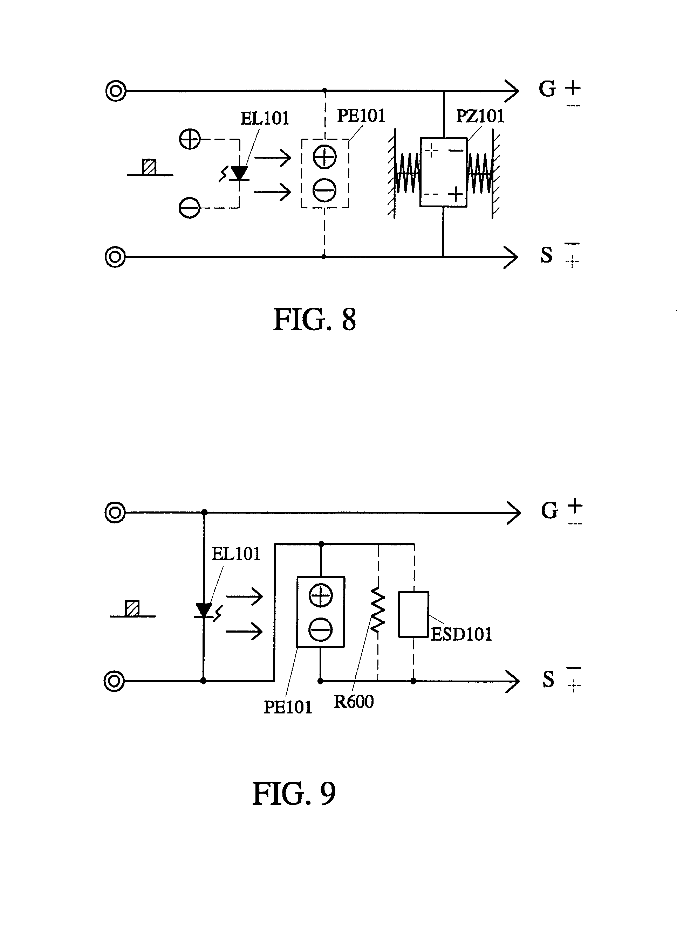

g. Fig. 8 shows that a slave negative voltage supply circuit is comprised of the present invention connected in parallel with a pressure effect device of pre-stressed structure. Within, a pressure effect device PZ101 of pre-stressed structure is connected in parallel between the drive signal source and the input end of the high input resistance transistor, the pressure effect device includes any device with pressure effect and is pre-compressed by means of the pre-stressed structure so that it is normally under negative voltage status when transmitted to the high input resistance transistor Q101, and the light emission device EL101 from the drive signal source is used to control the operation of the photoelectric conversion device PE101with selected voltage coupled to it to generate electricity when subject to light for generating a positive voltage to drive the high input resistance transistor Q101;meanwhile,by taking advantage of such pressure effect, the pressure effect device PZ101 indicates its transformation in opposite to the pre-stressed direction so that when the positive voltage drive signal is interrupted, the pressure effect device PZ101 indicates a status of negative voltage against the input end of the high input resistance transistor Q101 by pre-stress restoration for improving its cutoff characteristics;
h . Fig. 9 shows that a slave negative voltage supply circuit is comprised of the present invention and a photoelectric conversion device connected in series of inverse polarity with the drive signal. Within, the photoelectric conversion device PE101 with selected output voltage is connected in series of inverse polarity between the drive signal source and the input of the high input resistance transistor, and the secondary electricity storage device ESD101 comprised of a capacitor or a secondary (dis) chargeable battery is connected in parallel with both ends of the photoelectric conversion device, or a secondary resistance R600 may be further connected in parallel as required while the electric energy driven light emission device EL101 in parallel with the input end of the drive signal is coupled to the photoelectric conversion device PE101. In addition to driving the high input resistance transistor Q101, the input of electric energy from the positive voltage signal also causes the electric energy driven light emission device EL101 to emit the light at the same time so to excite the photoelectric conversion device PE101 for generating output of negative voltage and charging the secondary electricity storage device ESD101 provided that upon the electric energy of the positive voltage signal being interrupted, the secondary electricity storage device ESD101 delivers a negative voltage into the input end of the high input resistance transistor Q101 to improve its cutoff characteristics;

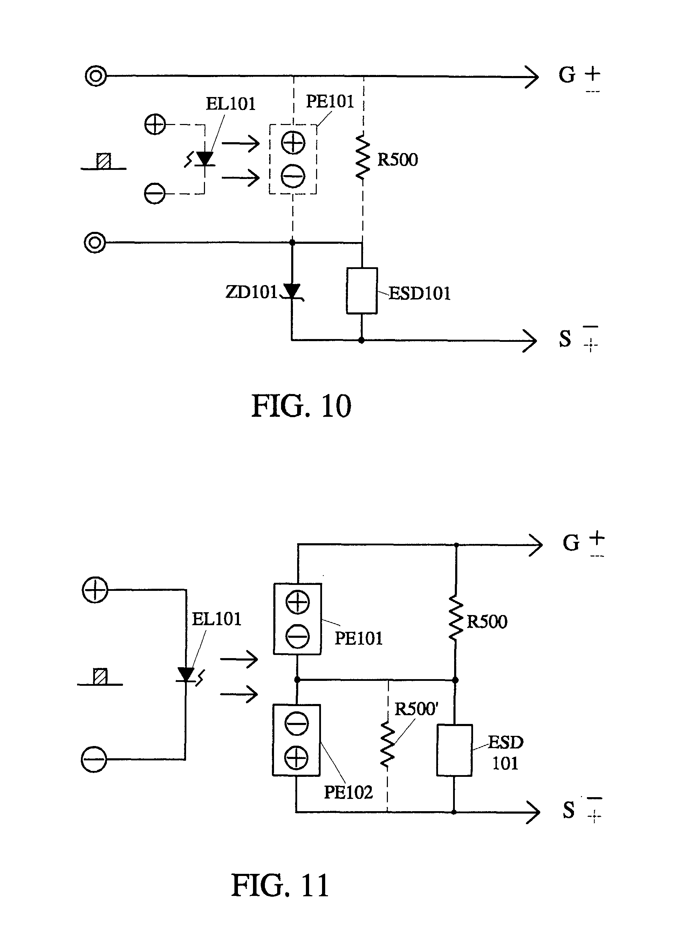

i. Fig. 10 shows that a slave negative voltage circuit is comprised of a zener diode and capacitors connected in series at the output end of the photoelectric conversion device coupled to the electric energy driven light emission device of the present invention. Within, the drive signal source is used to drive the electric energy driven light emission device EL101 to excite the photoelectric conversion device PE101 with selected output voltage coupled to the electric energy driven light emission device EL101, and a zener diode ZD101 and the secondary electricity storage device ESD101 comprised of a capacitor or a secondary (dis)chargeable battery connected in parallel with both ends of the zener diode are connected in series between the photoelectric conversion device and the input end of the high input resistance transistor Q101 so that upon the electric energy from an external signal source is inputted, or when the photoelectric conversion device PE101 coupled as controlled by the electric energy driven light emission deviceEL101generateselectricityfor being subject to the light to drive the high input resistance transistor Q101 through the zener diode ZD101, and to charge the secondary electricity device ESD101 in parallel with both ends of the zener diode ZD101; when the signal of positive voltage is interrupted, the secondary electricity device ESD101 indicates input of negative voltage to the input end of the high input resistance transistor Q101 to improve its cutoff characteristics; if required, the secondary resistance R500 may be connected in parallel with the output end of the photoelectric conversion device;
j . Fig. 11 shows that the electric energy driven light emission device provided at the signal source of the present invention is used to simultaneously excite two photoelectric conversion devices connected in series of inverse polarity that are coupled to the electric energy driven light emission device while an electricity storage device circuit for negative voltage is also provided. Within, the drive signal source is used to drive the electric energy driven light emission device EL101 to excite two photoelectric conversion devices PE101 and PE102 of different values of rated output voltage connected in series of inverse polarity and indicating input polarity of negative voltage with the input end of the high input resistance transistor Q101 in the photo energy driven light emission device, the secondary electricity storage device ESD101 comprised of capacitors or the secondary (dis) chargeable battery is connected in parallel with both output ends of the photoelectric conversion device PE102 having the lower rated output voltage; upon the input of electric energy from the positive voltage signal, the electric energy driven light emission device EL101 is excited to emit light, both of the two photoelectric conversion devices PE101 containing higher rated output voltage and PE102 having the lower rated output voltage that are connected in series in inverse direction and coupled to the electric energy driven light emission device EL101 are excited to generate electricity at the same time; meanwhile the circuit indicates at the input end of the high input resistance transistor Q101 a positive voltage input of the voltage difference between the two photoelectric conversion devices PE101 and PE102 so to conduct the high input resistance transistor Q101 and to execute negative voltage charging on the secondary electricity storage device ESD101, then the electric energy is outputted through the secondary resistance R500 to the high input resistance transistor Q101 to facilitate its cut-off conduction; furthermore, the secondary resistance R500'may be connected in parallel with both ends of the secondary electricity storage device ESD101 as required by the circuit;

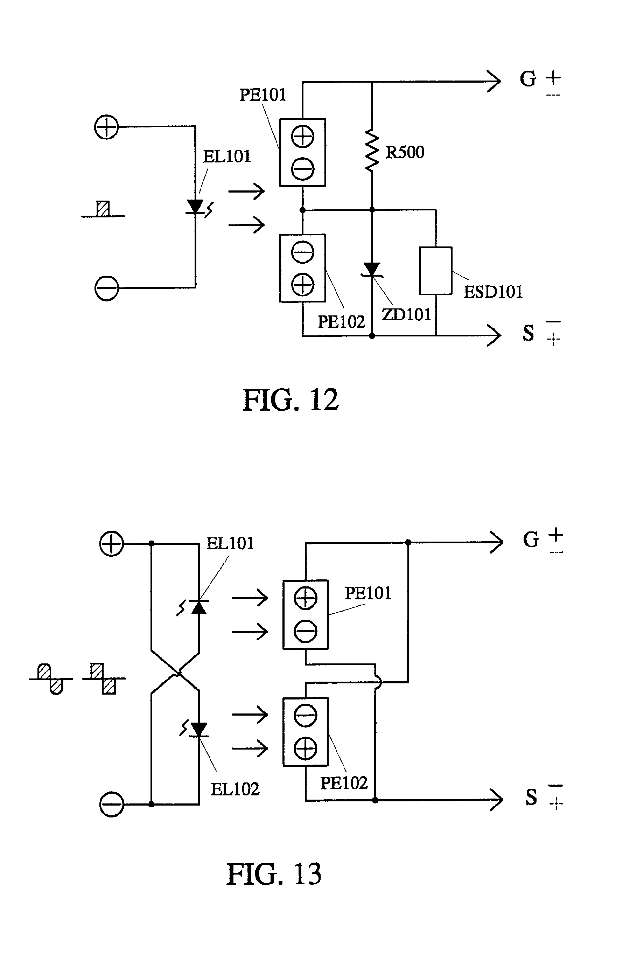

k. Fig. 12 shows another example of the electric energy driven light emission device provided at the signal source of the present invention is used to simultaneously excite two photoelectric conversion devices connected in series of inverse polarity that are coupled to the electric energy driven light emission device while an electricity storage device circuit for negative voltage is also provided. Within, the drive signal source is used to drive the electric energy driven light emission device EL101 to excite two photoelectric conversion devices PE101 and PE102 with selected output voltage connected in series of inverse polarity and indicating input polarity of negative voltage with the input end of the high input resistance transistor Q101 in the photo energy driven light emission device, the secondary electricity storage device ESD101 comprised of capacitors or the secondary (dis)chargeable battery is connected in parallel with both output ends of the photoelectric conversion device PE102 and is further connected in parallel with the zener diode ZD101 having its zener voltage lower than the rated voltage of the photoelectric conversion device PE101; upon the input of electric energy from the positive voltage signal, the electric energy driven light emission device EL101 is excited to emit light, both of the two photoelectric conversion devices PE101 and PE102 that are connected in series in inverse direction and coupled to the electric energy driven light emission device EL101 are excited to generate electricity at the same time; meanwhile the circuit indicates at the input end of the high input resistance transistor Q101 a positive voltage input through the zener diode ZD101 to conduct the high input resistance transistor Q101 and to execute negative voltage charging on the secondary electricity storage device ESD101 connected in parallel with both ends of the zener diode; when the electric energy from the positive voltage signal is interrupted and the electric energy driven light emission device EL101 stops light emission, the electric energy of negative voltage from the secondary electricity storage device ESD101 is outputted through the secondary resistance R500 connected in parallel with both ends of the photoelectric conversion device PE101 to the high input resistance transistor Q101 to facilitate its cut-off conduction;
l. As illustrated in Fig. 13, a circuit of the present invention is comprised of two electric energy driven light emission devices EL101 and EL102 driven by selected electric energy polarity adapted with two photoelectric conversion devices PE101, PE102 connected in parallel of inverse polarity. Within, the two electric energy driven light emission devices EL101 and EL102 driven by 2-way drive signal source, and two photoelectric conversion devices PE101 and PE102 with selected output voltage connected in parallel of inverse polarity and coupled to the two electric energy driven light emission devices EL101 and EL102 are used to output to the input end of the high input resistance transistor Q101. When the input signal source relates to positive conduction signal to drive the positive conduction electric energy driven light emission device EL101 to emit the light, thus to cause the photoelectric conversion device PE101 coupled to it also excited for light emission to generate electric energy of positive polarity to drive the high input resistance transistor Q101 to be conducted; when the positive signal from the input signal source is cut off and turned into negative signal, the electric energy of positive polarity outputted to the high resistance transistor is cut off while the other unit for cutoff, i.e. the electric energy driven light emission device EL102 emitting the light in inverse direction emits the light, thus to excite the photoelectric conversion device PE102 coupled to it for emitting the light to generate electric energy of negative polarity outputting to the input end of the high input resistance transistor Q101 for improving its cutoff characteristics;

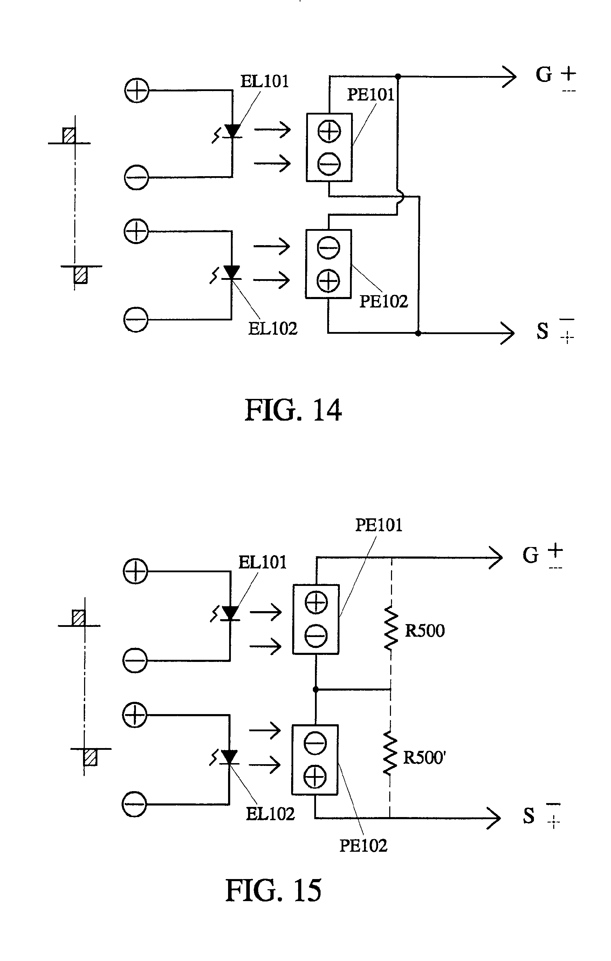

m. Fig. 14 shows that a circuit comprised of two individual electric energy driven light emission devices is used to control the operation of two photoelectric conversion devices connected in parallel of inverse polarity. Within, the two individual electric energy driven light emission devices EL101 and EL102 driven by a 2-way drive signal source, and the two photoelectric conversion devices PE101 and PE102 provided with a selected output voltage and connected in parallel of inverse polarity are used to output to where between input ends of the high input resistance transistor Q101. When the input signal source relates to positive conduction signal to drive its matching electric energy driven light emission device EL101 to be excited for emitting the light, the photoelectric conversion device PE101 coupled to it generates electricity from receiving the light to generate electric energy of positive polarity to drive the high input resistance transistor Q101 for it to turn to be conducted; when the positive signal from the input signal source is cut off and turns into negative signal,theelectric energy ofpositive polarity outputting to the high input resistance transistor Q101 is also cut off while the other photoelectric conversion device PE102 used also for cutoff starts to emit the light to generate electric energy of negative polarity for outputting to the input end of the high input resistance transistor Q101 to improve its cutoff characteristics;
n. Fig. 15 shows that a circuit of the present invention controls the operation of two photoelectric conversion devices indicating inverse polarity with two individual light emission devices driven by electric energy. Within, two respectively provided electric energy driven light emission devices EL101 and EL102 driven by a two-way drive signal source, and two photoelectric conversion devices PE101 and PE102 with selected output voltage connected in series of inverse polarity and coupled to the two individual electric energy driven light emission devices EL101 and EL102 are used to output to where between the input ends of the high input resistance transistor Q101. When the input signal source relates to positive conduction signal to drive its matching electric energy driven light emission device EL101 to be excited for emitting the light, the photoelectric conversion device PE101 coupled to it generates electricity from receiving the light to generate electric energy of positive polarity to drive the high input resistance transistor Q101 for it to turn to be conducted; when the positive signal from the input signal source is cut off and turns into negative signal, the electric energy of positive polarity outputting to the high input resistance transistor Q101 is also cut off while the other photoelectric conversion device EL102 used also for cutoff starts to emit the light to generate electric energy of negative polarity for outputting to the input end of the high input resistance transistor Q101 to improve its cutoff characteristics. The individual output end of the two photoelectric conversion devices connected in series of inverse polarity may be respectively connected in parallel with the resistance R500 and R500' as required;
o . Fig. 16 shows a first preferred embodiment of the present invention provided with a source of negative polarity. Within, a fixed source or a drive signal is used to drive an electric energy driven light emission device EL102 to generate photo energy for exciting the photoelectric conversion device PE102 for generating electric energy of negative polarity that is coupled to the electric energy driven light emission device EL102, while the drive signal source is directly inputted or drives to control the operation of the electric energy driven light emission device EL101 to relatively generate photo energy for exciting the photoelectric conversion device PE101coupled to it and provided for generating electric energy of positive polarity, then the photo energy is further outputted to the input end of the high input resistance transistor Q101 with both input ends of the high input resistance transistor Q101 connected in parallel and further connected in series with a secondary resistance R700 and another resistance R700' ; and the photoelectric conversion device PE102 provided for generating electric energy of negative polarity indicates inverse polarity to be connected in parallel with the secondary resistance R700' for constantly indicating electric energy of negative polarity to the input end of the high input resistance transistor Q101. When the drive signal source is interrupted, the electric energy of positive polarity outputted to the high input resistance transistor Q101 is also cut off, the electric energy of negative polarity outputted from the photoelectric conversion device PE102 is conducted to the high input resistance transistor Q101 to improve its cutoff characteristics; the fixed source may come from a main power or a dedicated secondary power source or a secondary source shared by other source circuit;
p . Fig. 17 shows a second preferred embodiment of the present invention provided with a source of negative polarity. Within, a fixed source or a drive signal is used to drive an electric energy driven light emission device EL102 to generate photo energy for exciting the photoelectric conversion device PE102 for generating electric energy of negative polarity that is coupled to the electric energy driven light emission device EL102, while the drive signal source is directly inputted or drives to control the operation of the electric energy driven light emission device EL101 to relatively generate photo energy for exciting the photoelectric conversion device PE101 coupled to it and provided for generating electric energy of positive polarity, then the photo energy is further outputted to the input end of the high input resistance transistor Q101 with both input ends of the high input resistance transistor Q101 connected in parallel with a circuit comprised of a secondary resistance R700 and the secondary electricity device ESD101 connected in series; and the photoelectric conversion device PE102 provided for generating electric energy of negative polarity indicates inverse polarity to be connected in parallel with the secondary electricity storage device ESD101 for constantly indicating electric energy of negative polarity to the input end of the high input resistance transistor Q101. When the drive signal source is interrupted, the electric energy of positive polarity outputted to the high input resistance transistor Q101 is also cut off, the electric energy of negative polarity outputted from the photoelectric conversion device PE102 is conducted to the high input resistance transistor Q101 to improve its cutoff characteristics; the fixed source may come from a main power or a dedicated secondary power source or a secondary source shared by other source circuit and a secondary resistance R700' may be or may not be respectively provided to both ends of the photoelectric conversion device PE102; and

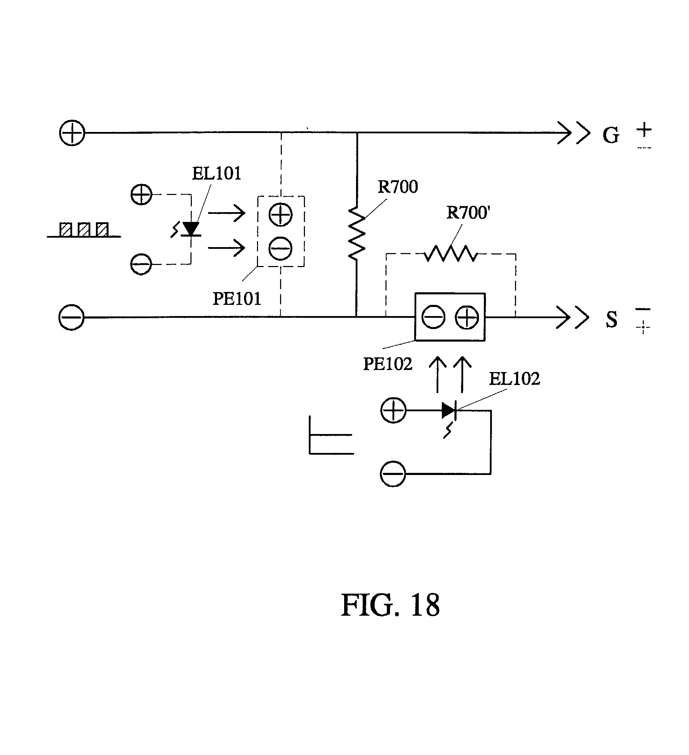

q. Fig. 18 shows a third preferred embodiment of the presentation provided with a power source of negative polarity. Within, a fixed source or a drive signal is used to drive an electric energy driven light emission device EL102 to generate photo energy for exciting the photoelectric conversion device PE102 for generating electric energy of negative polarity that is coupled to the electric energy driven light emission device EL102, while the drive signal source is directly inputted or drives to control the operation of the electric energy driven light emission device EL101 to relatively generate photo energy for exciting the photoelectric conversion device PE101 coupled to it and provided for generating electric energy of positive polarity, when both output ends of the photoelectric conversion device PE101 is connected in parallel with the secondary resistance R700, and then further connected in series with the photoelectric conversion device PE102 of inverse polarity and inputted to the input end of the high resistance transistor Q101, the voltage of rated output electric energy of the photoelectric conversion device PE102 provided for generating the electric energy of negative polarity is lower than the voltage of the rated output voltage of the photoelectric conversion device PE102 constant to its inputted electric energy of negative polarity without affecting the control by the drive signal over the operation of the high input resistance transistor Q101. When the drive signal source is interrupted, the electric energy of positive polarity outputted to the high input resistance transistor Q101 is also cut off, the electric energy of negative polarity is outputted to the high input resistance transistor Q101 to improve its cutoff characteristics; the fixed source may come from a main power or a dedicated secondary power source or a secondary source shared by other source circuit, and a secondary resistance R700' may be or may not be respectively provided to both ends of the photoelectric conversion device PE102.

As disclosed above, the photoelectric conversion drive circuit of the transistor uses an electric energy driven light emission device or a natural light source from the environment as the working light source to control the operation of a photoelectric conversion device which when coupled to it and generates a drive voltage when subj ect to light and the operation of its adapted slave negative voltage supply circuit device VB101, thus to constitute a pilot drive circuit of a high input resistance transistor, such as a micro type or power type metal-oxide-silicon field effect transistor (MOSFET) or an insulated gate bi-carrier transistor (IGBT) or any other high input resistance transistor or modulus so that a high input resistance transistor, such as a micro type or power type metal-oxide-silicon field effect transistor (MOSFET) or an insulated gate bi-carrier transistor (IGBT) or any other high input resistance transistor achieves excellent control and operation either in the mode of drive or cutoff.

## Claims

1. A photoelectric conversion drive circuit of a transistor, wherein, a matching electric energy driven light emission device, such as LED, electric bulb or other type of electric-photo conversion light emission device or a natural light source from the environment and a photoelectric conversion device couple to it, such as a photoelectric cell of crystal or non-crystal system to generate voltage type drive electric energy of micro current for inputted to a high input resistance transistor, such as a micro or power type metal-oxide-silicon field effect transistor (MOSFET) or an insulated gate bi-carrier transistor (IGBT), or other type of high input resistance transistor to execute a driven conduction, while an electric energy of positive voltage for driving executes storage of electric energy to a slave negative voltage supply circuit device so that upon the cutoff, negative voltage is inputted to gate and emitter of one or more than one high resistance transistors to facilitate the cutoff.

2. A photoelectric conversion drive circuit of a transistor as claimed in Claim 1, wherein, the circuit is essentially comprised of:
- a high input resistance transistor Q101: comprised of one or more than one various types of high input resistance transistor devices, including one-unit one-polarity or two units inversely connected in parallel, or bridge type modulus high input resistance transistor such as an active device comprised of a metal-oxide-silicon field effect transistor (MOSFET) or an insulated gate bi-carrier transistor (IGBT), or other high input resistance transistor or modulus or gate, or constitutes logic operation or data memory storage system, or detection circuit device, or constitutes other circuit that is driven by receiving electric energy drive signal of positive voltage, or one or more than one an photoelectric conversion devices PE101 is provided for joint or individual matching as may be required to drive the high input resistance transistor Q101;
- a photoelectric conversion device PE101: comprised of a crystal or non-crystal system photo device that generates electric energy output when subject to light, or of other type of photoelectric conversion device to receive photo energy from an environmental light source or an electric energy driven light emission device EL101 and then the photo energy is converted into a minimum drive voltage required by the high input resistance transistor Q101 to drive the high input resistance transistor Q101; the electric energy driven light emission device EL101 comprised of one or more than one light emission diodes (LEDs) , electric bulb or any other type of photoelectric conversion device is matched to the an photoelectric conversion device PE101 in such way that the photo energy outputted generates the minimum drive voltage required by the photoelectric conversion device PE101; one or more than one electric energy driven light emission devices EL101 are used to drive the photoelectric conversion device PE101; or one or more than one electric energy driven light emission device EL101 are used to jointly drive the photoelectric conversion device PE101; or two or more than two electric energy driven light emission devices EL101 are used to respectively drive the photoelectric conversion device PE101; or two or more than two electric energy driven light emission devices EL101 are used to simultaneously drive two or more than two photoelectric conversion devices PE101; and one or more than one the electric energy driven light emission devices EL101 may be provided or not provided at all depending on the requirements of the circuit;
- a slave negative voltage supply circuit device VB101: comprised of solid-status or mechanic-electronic device to provide negative voltage upon cutting off for transmission to the control gate and emitter of the high input resistance transistor Q101 for facilitating the cutoff to be executed by the high input resistance transistor Q101; upon the delivery of the positive voltage electric energy signal controlling the drive, or when the photoelectric conversion device PE101 receives the photo energy emitted from the electric energy driven light emission device EL101 or from the environment to generate positive voltage to drive the high input resistance transistor Q101, the slave negative voltage supply circuit device VB101 executes storage of negative voltage at the same by means of electric energy of the inputted positive voltage signal so that when the positive voltage signal transmitting to the high input resistance transistor Q101 is interrupted, the slave negative voltage supply circuit device VB101 inputs negative voltage to the controlling gate and emitter of the high input resistance transistor Q101 to facilitate cut-off transition; the negative voltage electric energy of the slave negative voltage supply circuit device VB101 may come from a photoelectric conversion device includes that from the photoelectric conversion devices PE101 or an independently provided photoelectric conversion device PE102, or that positive voltage electric energy from other drive signal source; and the negative voltage storage is **characterized by** a mechanic-electronic device, an inductive device, a capacity device, a (dis)rechargeable secondary battery or a super capacitor, or other type of electricity storage device to store electric energy of positive voltage required for driving the high input resistance transistor Q101;
- a loading device LD101: includes a load generating mechanical energy, photo, thermal or electrochemical effect by inputting electric energy, or any other power load comprised of resistive, capacity, inductive load or transistor or diode or any other solid-status or mechanical-electronic load device, or any circuit load functioning for post amplification, or any load for signal transmission, or any load for data storage or read-out or elimination or operation, or any load functioning as a detection circuit device or any other circuit load to be subject to the control by the high input resistance transistor Q101.

3. A photoelectric conversion drive circuit of a transistor as claimed in Claim 1, wherein, depending on the structural requirements, the electric energy driven light emission device EL101, the photoelectric conversion device PE101 and the slave negative voltage supply circuit device VB101 may be of individual structure, or mutually coupled, or partially or generally coupled to form a sealed configuration.

4. A photoelectric conversion drive circuit of a transistor as claimed in Claim 1, wherein, depending on the structural requirements, the electric energy driven light emission device EL101, the photoelectric conversion device PE101 and the slave negative voltage supply circuit device VB101 may be partially or generally separately provided or packed into a modulus with the high input resistance transistor Q101.

5. A photoelectric conversion drive circuit of a transistor as claimed in Claim 1, wherein, each and all related circuit devices may be directly connected or connected via an I/C or a PCB to form an open structure or a hybrid structure.

6. A photoelectric conversion drive circuit of a transistor as claimed in Claim 1, wherein, the drive source for the energy driven light emission device EL101 may be of DC or AC source to drive the bulb, or comprised of DC electric energy driven light emission diode (LED), or laser light source or other electric energy excited electric energy driven light emission device, or may be substituted with a natural light source from the environment.

7. A photoelectric conversion drive circuit of a transistor as claimed in Claim 1, wherein, the slave negative voltage supply circuit device VB101 is connected in parallel with an induction L101 so that when an external signal source or the positive voltage signal source used to drive the high input resistance transistor Q101 supplied from the photoelectric conversion device PE101 with selected output voltage coupled as controlled by the electric energy driven light emission device EL101 is interrupted, the induction L101 then generates a inverse negative voltage to the input end of the high input resistance transistor Q101 to improve its cutoff characteristics.

8. A photoelectric conversion drive circuit of a transistor as claimed in Claim 1, wherein, the slave negative voltage supply circuit device VB101 is connected in parallel with induction L101 and capacitors C101 so that when an external signal source or the positive voltage signal source used to drive the high input resistance transistor Q101 supplied from the photoelectric conversion device PE101 with selected output voltage coupled as controlled by the electric energy driven light emission device EL101 is interrupted, the induction L101 and the capacitor C101 connected in parallel are used to generate inverse negative voltage to the input end of the high resistance transistor Q101 to improve its cutoff characteristics.

9. A photoelectric conversion drive circuit of a transistor as claimed in Claim 1, wherein, the slave negative voltage supply circuit device VB101 comprised of the present invention in series with an induction. Within, the induction L101 is connected in series between the input of the high input resistance transistor Q101 and a signal source of drive positive voltage so that when an external signal source or the positive voltage signal source used to drive the high input resistance transistor Q101 supplied from the photoelectric conversion device PE101 with selected output voltage coupled as controlled by the electric energy driven light emission device EL101 is interrupted, the induction L101 is connected in series between the signal source of drive positive voltage and the high input resistance transistor Q101 generates an inverse negative voltage to the input end of the high input resistance transistor Q101 to improve its cutoff characteristics, and a secondary resistance R500 may be connected in parallel with both ends of the photoelectric conversion device PE101 as required to provide a loop for the inverse negative voltage.

10. A photoelectric conversion drive circuit of a transistor as claimed in Claim 1, wherein, the slave negative voltage supply circuit device VB101 is connected in series with an induction L101 and capacitors C101 connected in parallel so that when an external signal source or the positive voltage signal source used to drive the high input resistance transistor Q101 supplied from the photoelectric conversion device PE101 with selected output voltage coupled as controlled by the electric energy driven light emission device EL101 is interrupted, a parallel harmonic oscillation is formed comprising of the induction L101 and the capacitors C101 in parallel is connected in series between the high input resistance transistor Q101 and the signal source of drive positive voltage, and an inverse negative voltage is generated to the input end of the high input resistance transistor Q101 to improve its cutoff characteristics while a secondary resistance R500 may be connected as required in parallel with both ends of the photoelectric conversion device PE101 to provide a loop of inverse negative voltage.

11. A photoelectric conversion drive circuit of a transistor as claimed in Claim 1, wherein, the slave negative voltage supply circuit device VB101 is connected in series with resistance and a secondary battery system comprised of a combination of a resistance R400 and a secondary electricity storage device ESD101 in parallel is comprised of having the secondary battery system ESD101 comprised of the capacitor or the secondary (dis) chargeable battery and the resistance R400 in parallel to be connected in series between the drive signal source and the input of the high input resistance transistor Q101, and the secondary resistance R500 is connected in parallel with either side of a connection of the combination of the drive signal source and the resistance R400 connected in parallel with the secondary electricity storage device ESD101 and another end from the signal source of the drive positive voltage so to have the drive signal source or the photoelectric conversion device PE101 with the selected output voltage coupled as controlled by the electric energy driven light emission device EL101 to generate electricity when subject to light, thus to generate positive voltage to drive the high input resistance transistor Q101; and in addition to driving the high input resistance transistor Q101, the positive voltage also forms a voltage drop to the resistance R400 provided in the combination of the resistance R400 and the secondary electricity storage device ESD101 connected in parallel, so to charge the negative voltage into both ends of the secondary electricity storage device ESD101; furthermore, when the signal source of the positive voltage is interrupted, the negative voltage stored in the secondary electricity storage device ESD101 forms through the secondary resistance R500 a negative voltage to the input end of the high input resistance transistor Q101 to improve its cutoff characteristics.

12. A photoelectric conversion drive circuit of a transistor as claimed in Claim 1, wherein, the slave negative voltage supply circuit device VB101 is connected between the drive signal source and the input end of the high input resistance transistor Q101 a secondary electricity storage device ESD101 comprised of a capacitor or a secondary (dis)chargeable battery in series with a combination of a zener diode ZD101 and a secondary electricity storage device ESD101 in parallel, and a secondary resistance R500 and another secondary resistance R500' are respectively connected in parallel with both ends of the combination of the zener diode ZD101 in parallel and the drive signal source so to have the drive signal source or the photoelectric conversion device PE101 with the selected output voltage coupled as controlled by the electric energy driven light emission device EL101 to generate electricity when subject to light, thus to generate positive voltage to drive the high input resistance transistor Q101; and in addition to driving the high input resistance transistor Q101, zener voltage of the zener diode ZD101 is used to form a voltage drop at both ends of the secondary electricity device ESD101 so to charge the negative voltage into both ends of the secondary electricity storage device ESD101; when the signal source of the positive voltage is interrupted, the negative voltage stored in the secondary electricity storage device ESD101 forms through the secondary resistance R500 and R500' a negative voltage to the input end of the high input resistance transistor Q101 to improve its cutoff characteristics.

13. A photoelectric conversion drive circuit of a transistor as claimed in Claim 1, wherein, the slave negative voltage supply circuit device VB101 is connected in parallel with a pressure effect device PZ101 of pre-stressed structure is connected in parallel between the drive signal source and the input end of the high input resistance transistor, thepressureeffectdeviceincludesanydevicewithpressure effect and is pre-compressed by means of the pre-stressed structure so that it is normally under negative voltage status when transmitted to the high input resistance transistor Q101, and the light emission device EL101 from the drive signal source is used to control the operation of the photoelectric conversion device PE101 with selected voltage coupled to it to generate electricity when subject to light for generating a positive voltage to drive the high input resistance transistor Q101; meanwhile, by taking advantage of such pressure effect, the pressure effect device PA101 indicates its transformation in opposite to the pre-stressed direction so that when the positive voltage drive signal is interrupted, the pressure effect device PA101 indicates a status of negative voltage against the input end of the high input resistance transistor Q101 by pre-stress restoration for improving its cutoff characteristics.

14. A photoelectric conversion drive circuit of a transistor as claimed in Claim 1, wherein, the slave negative voltage supply circuit device VB101 is connected in series of inverse polarity with a photoelectric conversion device PE101 with selected output voltage between the drive signal source and the input of the high input resistance transistor, and the secondary electricity storage device ESD101 comprised of a capacitor or a secondary (dis)chargeable battery is connected in parallel with both ends of the photoelectric conversion device, or a secondary resistance R600 may be further connected in parallel as required while the electric energy driven light emission device EL101 in parallel with the input end of the drive signal is coupled to the photoelectric conversion device PE101. In addition to driving the high input resistance transistor Q101, the input of electric energy from the positive voltage signal also causes the electric energy driven light emission device EL101 to emit the light at the same time so to excite the photoelectric conversion device PE101 for generating output of negative voltage and charging the secondary electricity storage device ESD101 provided that upon the electric energy of the positive voltage signal being interrupted, the secondary electricity storage device ESD101 delivers a negative voltage into the input end of the high input resistance transistor Q101 to improve its cutoff characteristics.

15. A photoelectric conversion drive circuit of a transistor as claimed in Claim 1, wherein, the slave negative voltage circuit device VB101 has the drive signal source to drive the electric energy driven light emission device EL101 to excite the photoelectric conversion device PE101 with selected output voltage coupled to the electric energy driven light emission device EL101, and a zener diode ZD101 and the secondary electricity storage device ESD101 comprised of a capacitor or a secondary (dis)chargeable battery connected in parallel with both ends of the zener diode are connected in series between the photoelectric conversion device and the input end of the high input resistance transistor Q101 so that upon the electric energy from an external signal source is inputted, or when the photoelectric conversion device PE101 coupled as controlled by the electric energy driven light emission device EL101 generates electricity for being subject to the light to drive the high input resistance transistor Q101 through the zener diode ZD101, and to charge the secondary electricity device ESD101 in parallel with both ends of the zener diode ZD101; when the signal of positive voltage is interrupted, the secondary electricity device ESD101 indicates input of negative voltage to the input end of the high input resistance transistor Q101 to improve its cutoff characteristics; if required, the secondary resistance R500 may be connected in parallel with the output end of the photoelectric conversion device.

16. A photoelectric conversion drive circuit of a transistor as claimed in Claim 1, wherein, the slave negative voltage supply circuit device VB101 has the drive signal source to drive the electric energy driven light emission device EL101 to excite two photoelectric conversion devices PE101 and PE102 of different values of rated output voltage connected in series of inverse polarity and indicating input polarity of negative voltage with the input end of the high input resistance transistor Q101 in the photo energy driven light emission device, the secondary electricity storage device ESD101 comprised of capacitors or the secondary (dis) chargeable battery is connected in parallel with both output ends of the photoelectric conversion device PE102 having the lower rated output voltage; upon the input of electric energy from the positive voltage signal, the electric energy driven light emission device EL101 is excited to emit light, both of the two photoelectric conversion devices PE101 containing higher rated output voltage and PE102 having the lower rated output voltage that are connected in series in inverse direction and coupled to the electric energy driven light emission device EL101 are excited to generate electricity at the same time; meanwhile the circuit indicates at the input end of the high input resistance transistor Q101 a positive voltage input of the voltage difference between the two photoelectric conversion devices PE101 and PE102 so to conduct the high input resistance transistor Q101 and to execute negative voltage charging on the secondary electricity storage device ESD101, then the electric energy is outputted through the secondary resistance R500 to the high input resistance transistor Q101 to facilitate its cut-off conduction; furthermore, the secondary resistance R500' may be connected in parallel with both ends of the secondary electricity storage device ESD101 as required by the circuit.

17. A photoelectric conversion drive circuit of a transistor as claimed in Claim 1, wherein, the slave negative voltage supply circuit device VB101 has the drive signal source to drive the electric energy driven light emission device EL101 to excite two photoelectric conversion devices PE101 and PE102 with selected output voltage connected in series of inverse polarity and indicating input polarity of negative voltage with the input end of the high input resistance transistor Q101 in the photo energy driven light emission device, the secondary electricity storage device ESD101 comprised of capacitors or the secondary (dis)chargeable battery is connected in parallel with both output ends of the photoelectric conversion device PE102 and is further connected in parallel with the zener diode ZD101 having its zener voltage lower than the rated voltage of the photoelectric conversion device PE101; upon the input of electric energy from the positive voltage signal, the electric energy driven light emission device EL101 is excited to emit light, both of the two photoelectric conversion devices PE101 and PE102 that are connected in series in inverse direction and coupled to the electric energy driven light emission device EL101 are excited to generate electricity at the same time; meanwhile the circuit indicates at the input end of the high input resistance transistor Q101 a positive voltage input through the zener diode ZD101 to conduct the high input resistance transistor Q101 and to execute negative voltage charging on the secondary electricity storage device ESD101 connected in parallel with both ends of the zener diode; when the electric energy from the positive voltage signal is interrupted and the electric energy driven light emission device EL101 stops light emission, the electric energy of negative voltage from the secondary electricity storage device ESD101 is outputted through the secondary resistance R500 connected in parallel with both ends of the photoelectric conversion device PE101 to the high input resistance transistor Q101 to facilitate its cut-off conduction.

18. A photoelectric conversion drive circuit of a transistor as claimed in Claim 1, wherein, the slave negative voltage circuit device VB101 has two electric energy driven light emission devices EL101 and EL102 driven by 2-way drive signal source, and two photoelectric conversion devices PE101 and PE102 with selected output voltage connected in parallel of inverse polarity and coupled to the two electric energy driven light emission devices EL101 and EL102 are used to output to the input end of the high input resistance transistor Q101. When the input signal source relates to positive conduction signal to drive the positive conduction electric energy driven light emission device EL101 to emit the light, thus to cause the photoelectric conversion device PE101 coupled to it also excited for light emission to generate electric energy of positive polarity to drive the high input resistance transistor Q101 to be conducted; when the positive signal from the input signal source is cut off and turned into negative signal, the electric energy of positive polarity outputted to the high resistance transistor is cut off while the other unit for cutoff, i.e. the electric energy driven light emission device EL102 emitting the light in inverse direction emits the light, thus to excite the photoelectric conversion device PE102 coupled to it for emitting the light to generate electric energy of negative polarity outputting to the input end of the high input resistance transistor Q101 for improving its cutoff characteristics.

19. A photoelectric conversion drive circuit of a transistor as claimed in Claim 1, wherein, the slave negative voltage supply circuit device VB101 has the two individual electric energy driven light emission devices EL101 and EL102 driven by a 2-way drive signal source, and the two photoelectric conversion devices PE101 and PE102 provided with a selected output voltage and connected in parallel of inverse polarity are used to output to where between input ends of the high input resistance transistor Q101. When the input signal source relates to positive conduction signal to drive its matching electric energy driven light emission device EL101 to be excited for emitting the light, the photoelectric conversion device PE101 coupled to it generates electricity from receiving the light to generate electric energy of positive polarity to drive the high input resistance transistor Q101 for it to turn to be conducted; when the positive signal from the input signal source is cut off and turns into negative signal, the electric energy of positive polarity outputting to the high input resistance transistor Q101 is also cut off while the other photoelectric conversion device PE102 used also for cutoff starts to emit the light to generate electric energy of negative polarity for outputting to the input end of the high input resistance transistor Q101 to improve its cutoff characteristics.

20. A photoelectric conversion drive circuit of a transistor as claimed in Claim 1, wherein the slave negative voltage supply circuit device VB101 has two respectively provided electric energy driven light emission devices EL101 and EL102 driven by a two-way drive signal source, and two photoelectric conversion devices PE101 and PE102 with selected output voltage connected in series of inverse polarity and coupled to the two individual electric energy driven light emission devices EL101 and EL102 are used to output to where between the input ends of the high input resistance transistor Q101. When the input signal source relates to positive conduction signal to drive its matching electric energy driven light emission device EL101 to be excited for emitting the light, the photoelectric conversion device PE101coupled to it generates electricity from receiving the light to generate electric energy of positive polarity to drive the high input resistance transistor Q101 for it to turn to be conducted; when the positive signal from the input signal source is cut off and turns into negative signal, the electric energy of positive polarity outputting to the high input resistance transistor Q101 is also cut off while the other photoelectric conversion device PE102 used also for cutoff starts to emit the light to generate electric energy of negative polarity for outputting to the input end of the high input resistance transistor Q101 to improve its cutoff characteristics. The individual output end of the two photoelectric conversion devices connected in series of inverse polarity may be respectively connected in parallel with the resistance R500 and R500' as required.

21. A photoelectric conversion drive circuit of a transistor as claimed in Claim 1, wherein, the slave negative voltage supply circuit device VB101 has a fixed source or a drive signal is used to drive an electric energy driven light emission device EL102 to generate photo energy for exciting the photoelectric conversion device PE102 for generating electric energy of negative polarity that is coupled to the electric energy driven light emission device EL102, while the drive signal source is directly inputted or drives to control the operation of the electric energy driven light emission device EL101 to relatively generate photo energy for exciting the photoelectric conversion device PE101 coupled to it and provided for generating electric energy of positive polarity, then the photo energy is further outputted to the input end of the high input resistance transistor Q101 with both input ends of the high input resistance transistor Q101 connected in parallel and further connected in series with a secondary resistance R700 and another resistance R700' ; and the photoelectric conversion device PE102 provided for generating electric energy of negative polarity indicates inverse polarity to be connected in parallel with the secondary resistance R700' for constantly indicating electric energy of negative polarity to the input end of the high input resistance transistor Q101. When the drive signal source is interrupted, the electric energy of positive polarity outputted to the high input resistance transistor Q101 is also cut off, the electric energy of negative polarity outputted from the photoelectric conversion device PE102 is conducted to the high input resistance transistor Q101 to improve its cutoff characteristics; the fixed source may come from a main power or a dedicated secondary power source or a secondary source shared by other source circuit.

22. A photoelectric conversion drive circuit of a transistor as claimed in Claim 1, wherein, the slave negative voltage supply circuit device VB101 has a fixed source or a drive signal is used to drive an electric energy driven light emission device EL102 to generate photo energy for exciting the photoelectric conversion device PE102 for generating electric energy of negative polarity that is coupled to the electric energy driven light emission device EL102, while the drive signal source is directly inputted or drives to control the operation of the electric energy driven light emission device EL101 to relatively generate photo energy for exciting the photoelectric conversion device PE101 coupled to it and provided for generating electric energy of positive polarity, then the photo energy is further outputted to the input end of the high input resistance transistor Q101 with both input ends of the high input resistance transistor Q101 connected in parallel with a circuit comprised of a secondary resistance R700 and the secondary electricity device ESD101 connected in series; and the photoelectric conversion device PE102 provided for generating electric energy of negative polarity indicates inverse polarity to be connected in parallel with the secondary electricity storage device ESD101 for constantly indicating electric energy of negative polarity to the input end of the high input resistance transistor Q101. When the drive signal source is interrupted, the electric energy of positive polarity outputted to the high input resistance transistor Q101 is also cut off, the electric energy of negative polarity outputted from the photoelectric conversion device PE102 is conducted to the high input resistance transistor Q101 to improve its cutoff characteristics; the fixed source may come from a main power or a dedicated secondary power source or a secondary source shared by other source circuit and a secondary resistance R700' may be or may not be respectively provided to both ends of the photoelectric conversion device PE102.

23. A photoelectric conversion drive circuit of a transistor as claimed in Claim 1, wherein, the slave negative voltage supply circuit device VB101 has a fixed source or a drive signal is used to drive an electric energy driven light emission device EL102 to generate photo energy for exciting the photoelectric conversion device PE102 for generating electric energy of negative polarity that is coupled to the electric energy driven light emission device EL102, while the drive signal source is directly inputted or drives to control the operation of the electric energy driven light emission device EL101 to relatively generate photo energy for exciting the photoelectric conversion device PE101 coupled to it and provided for generating electric energy of positive polarity, when both output ends of the photoelectric conversion device PE101 is connected in parallel with the secondary resistance R700, and then further connected in series with the photoelectric conversion device PE102 of inverse polarity and inputted to the input end of the high resistance transistor Q101, the voltage of rated output electric energy of the photoelectric conversion device PE102 provided for generating the electric energy of negative polarity is lower than the voltage of the rated output voltage of the photoelectric conversion device PE102 constant to its inputted electric energy of negative polarity without affecting the control by the drive signal over the operation of the high input resistance transistor Q101. When the drive signal source is interrupted, the electric energy of positive polarity outputted to the high input resistance transistor Q101 is also cut off, the electric energy of negative polarity is outputted to the high input resistance transistor Q101 to improve its cut-off characteristics; the fixed source may come from a main power or a dedicated secondary power source or a secondary source shared by other source circuit, and a secondary resistance R700' may be or may not be respectively provided to both ends of the photoelectric conversion device PE102.

24. A transistor photoelectric conversion drive circuit for exciting a coupled photoelectric conversion device by electric energy driven light emission device or natural light source in the environment to generate electric energy of positive voltage to drive a metal-oxide silicon field-effect transistor (MOSFET) or insulated gate bipolar transistor (IGBT) or any other high input resistance transistor while electric energy is stored at a slave negative voltage supply circuit device by means of the electric energy of positive voltage so that, upon cut off of a signal of positive voltage, negative voltage is inputted to the gate and the emitter of one or more high input resistance transistors to facilitate cut-off.
